# EUROPEAN PATENT APPLICATION

(11) **EP 4 510 178 A2**
(43) Date of publication of application: **19.02.2025**
(21) Application number: 24193564.2
(22) Date of filing: 08.08.2024
(51) Int. Cl.: H01L 21/822, H01L 21/8234, H01L 27/06, H01L 27/088, H01L 29/06, H01L 29/66, H01L 29/775, H01L 29/786

(54) **INTEGRATED CIRCUIT DEVICE INCLUDING WIMPY TRANSISTOR STACK WITH THICK SOURCE/DRAIN ISOLATION LAYER AND METHODS OF FORMING THE SAME**

(30) Priority: 14.08.2023 US 202363519338 P; 01.03.2024 US 202418592999; 03.07.2024 KR 20240087799
(71) Applicant: Samsung Electronics Co., Ltd, Suwon-si, Gyeonggi-do 16677 (KR)
(72) Inventor: PARK, Panjae, San Jose, CA 95134 (US); KIM, Jintae, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

An integrated circuit device includes a wimpy transistor stack (TSw_1) on a substrate (100), wherein the wimpy transistor stack (TSw_1) comprises: an upper transistor comprising: a plurality of upper channel regions (402a) stacked in a vertical direction (Z); and an upper source/drain region (404a, 404b) that contacts at least one of the plurality of upper channel regions (402a); a lower transistor that is between the substrate (100) and the upper transistor and comprises: a plurality of lower channel regions (202a) stacked in the vertical direction (Z); and a lower source/drain region (204a, 204b) that contacts at least one of the plurality of lower channel regions (202a); and a source/drain isolation layer (302a) separating the upper source/drain region (404a, 404b) from the lower source/drain region (204a, 204b), wherein the source/drain isolation layer (302a) contacts a lowermost one of the plurality of upper channel regions (402a) and/or an uppermost one of the plurality of lower channel regions (202a).

## Description

### BACKGROUND

The present disclosure generally relates to the field of integrated circuit devices and, more particularly, to integrated circuit devices including stacked transistors.

Various structures of an integrated circuit device and methods of forming the same have been proposed to increase the integration density and to reduce leakage current and/or power consumption. For example, a transistor stack including multiple transistors vertically stacked has been proposed to increase the integration density.

### SUMMARY

An integrated circuit device may include a wimpy transistor stack on a substrate. The wimpy transistor stack may comprise: an upper transistor comprising: a plurality of upper channel regions stacked in a vertical direction; and an upper source/drain region that contacts at least one of the plurality of upper channel regions. The wimpy transistor stack may comprise a lower transistor that is between the substrate and the upper transistor and comprises: a plurality of lower channel regions stacked in the vertical direction; and a lower source/drain region that contacts at least one of the plurality of lower channel regions. The wimpy transistor stack may comprise a source/drain isolation layer separating the upper source/drain region from the lower source/drain region. For example, the source/drain isolation layer contacts a lowermost one of the plurality of upper channel regions and/or an uppermost one of the plurality of lower channel regions. For example, the source/drain isolation layer overlaps a lowermost one of the plurality of upper channel regions and/or an uppermost one of the plurality of lower channel regions in a horizontal direction. For example, a lowermost one of the plurality of upper channel regions is electrically isolated from the upper source/drain region, and/or an uppermost one of the plurality of lower channel regions is electrically isolated from the lower source/drain region.

A method of forming an integrated circuit device may include: forming a stack structure on a substrate, the stack structure including lower channel layers and lower sacrificial layers that are alternately stacked, an intergate insulator layer on the lower channel layers and lower sacrificial layers, and upper channel layers and upper sacrificial layers that are alternately stacked; etching the stack structure to form a wimpy transistor stack and a reference transistor stack; forming a first preliminary gate structure for the wimpy transistor stack and a second preliminary gate structure for the reference transistor stack; forming lower source/drain regions adjacent the wimpy transistor stack and the reference transistor stack; forming source/drain isolation layers on the source/drain regions, one of the source/drain isolation layers contacting a lowermost one of the upper channel layers or an uppermost one of the lower channel layers; and forming upper source/drain regions on the source/drain isolation layers.

### BRIEF DESCRIPTION OF THE DRAWINGS

FIG. 1 is a plan view of an integrated circuit device according to some embodiments.
FIG. 2 is cross-sectional views of the integrated circuit device taken along line A-A' in FIG. 1 according to some embodiments.
FIG. 3 is cross-sectional views of the integrated circuit device taken along line A-A' in FIG. 1 according to some embodiments.
FIG. 4 is cross-sectional views of the integrated circuit device taken along line A-A' in FIG. 1 according to some embodiments.
FIG. 5 is a flowchart of methods of forming an integrated circuit device according to some embodiments.
FIGS. 6 through 12 are cross-sectional views illustrating methods of forming an integrated circuit device according to some embodiments.
FIG. 13 is cross-sectional views of the integrated circuit device taken along line A-A' in FIG. 1 according to some embodiments.
FIG. 14 is cross-sectional views of the integrated circuit device taken along line A-A' in FIG. 1 according to some embodiments.
FIG. 15 is cross-sectional views of the integrated circuit device taken along line A-A' in FIG. 1 according to some embodiments.
FIGS. 16 through 22 are cross-sectional views illustrating methods of forming an integrated circuit device according to some embodiments.
FIG. 23 is a flowchart of methods of forming an integrated circuit device according to some embodiments.

### DETAILED DESCRIPTION

Some embodiments stem from a realization that it may be beneficial to provide a wimpy transistor in a specific area of an integrated circuit device to reduce leakage current and/or power consumption. As used herein a "wimpy transistor" is a transistor with one or more channels electrically isolated to reduce current therethrough. In that specific area, lower current flow through a wimpy transistor may be acceptable, and leakage current and/or power consumption may be reduced by the wimpy transistor.

In integrated circuit devices that use multi-channel transistors, the complexity of the process for reducing the number of channels (e.g., nanosheets) or reducing the width of channels may be high. Further, in a transistor stack, changing the channel width may be highly restricted in the process. According to some embodiments, wimpy transistors may be provided by changing the characteristics of the devices (e.g., a thickness of a source/drain isolation layer or a thickness of an intergate insulator), which does not significantly increase the process complexity, without substantially changing the existing design.

In some embodiments, a wimpy transistor stack may be configured by changing a thickness of a source/drain isolation layer that separates upper and lower source/drain regions. Specifically, the thickness of the source/drain isolation layer may be increased to electrically isolate at least one of channels of the wimpy transistor stack such that leakage current and/or power consumption may be reduced due to a lower current flow through the wimpy transistor stack.

In some embodiments, a wimpy transistor stack may be configured by changing the thickness of an intergate insulator (e.g., a middle dielectric isolation (MDI)) separating upper and lower gate structures. Specifically, the thickness of the intergate insulator may be increased to reduce the number of channels of the wimpy transistor stack. The number of channels of the wimpy transistor stack may be less than the number of channels of a reference transistor stack adjacent to the wimpy transistor stack. Due to the reduced number of the channels, current flow through the wimpy transistor stack may be reduced and thus leakage current and/or power consumption may also be reduced.

Example embodiments will be described in greater detail with reference to the attached figures. As used herein a vertical direction Z may be perpendicular to a back side of a substrate. X and Y horizontal directions may be parallel to the backside of the substrate, may be perpendicular to each other, and may each be perpendicular to the Z direction. The X, Y, and Z directions may be referred to a first, second, and third directions, respectively.

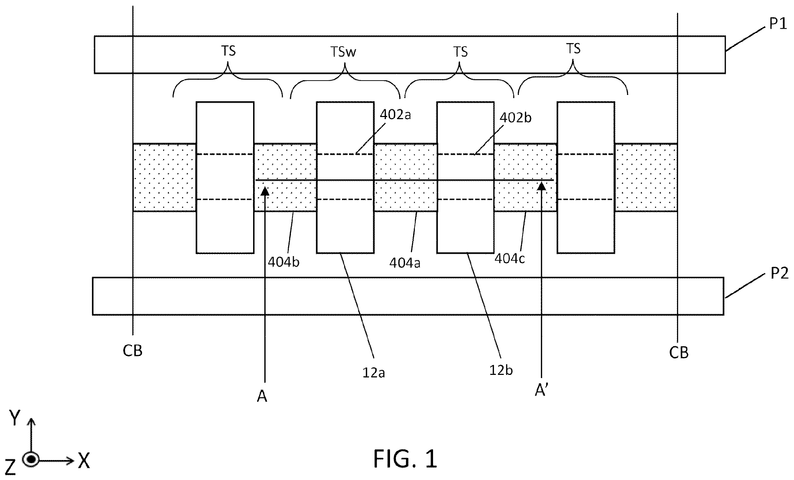

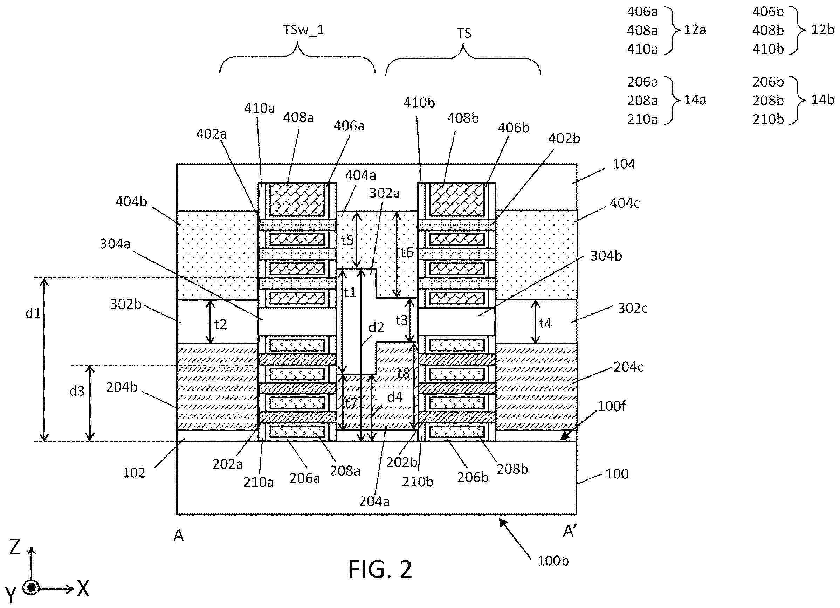

FIG. 1 is a schematic layout view of an integrated circuit device including a standard cell according to some embodiments, and FIGS. 2, 3 and 4 are cross-sectional views of the integrated circuit device taken along line A-A' in FIG. 1 according to some embodiments. Specifically, FIG. 1 is a schematic layout view of a single height standard cell that is defined between first and second power lines P1 and P2 and a pair of cell boundaries CB. The first power lines P1 may be electrically connected to a first power source having a first voltage (e.g., a drain voltage V_{DD}), and the second power lines P2 may be electrically connected to a second power source having a second voltage (e.g., a source voltage Vss). For example, the second voltage may be an electrical ground voltage. Although FIG. 1 illustrates a single height standard cell, the inventive concept is not limited thereto.

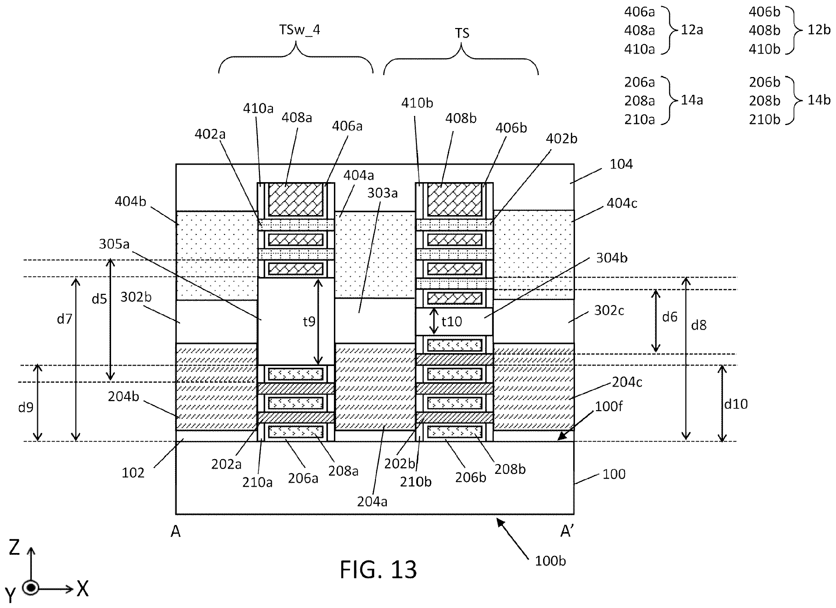

Referring to FIGS. 1 and 2, in some embodiments, the standard cell may include three reference transistor stacks TS (also referred to as transistor stacks) and one wimpy transistor stack TSw (e.g., TSw_1 in FIG. 2 or TSw_4 in FIG. 13). The wimpy transistor stack TSw_1 may include a first upper transistor (also referred to as an upper transistor) and a first lower transistor (also referred to as a lower transistor) that is between the first upper transistor and the substrate 100. The first upper transistor may include a plurality of first upper channel regions 402a (also referred to as a plurality of upper channel regions) that are stacked in a vertical direction Z, a first upper source/drain region 404a (also referred to an upper source/drain region), a second upper source/drain region 404b, and a first upper gate structure 12a. The first upper source/drain region 404a may contact at least one of the plurality of first upper channel regions 402a. For example, the first upper source/drain region 404a may contact two of the first upper channel regions 402a among three of the first upper channel regions 402a.

The first upper gate structure 12a may include a first upper gate insulator 406a, a first upper gate electrode 408a and a first upper gate spacer 410a. The plurality of first upper channel regions 402a may be provided in the first upper gate structure 12a. The first upper source/drain region 404a and the second upper source/drain region 404b may be spaced apart from each other in a first direction X (also referred to as a first horizontal direction or a horizontal direction). The vertical direction Z may be perpendicular to a back side 100b of the substrate 100. The substrate 100 may also include a front side 100f that is opposite the back side 100b and faces the wimpy transistor stack TSw_1. In some embodiments, the first and second power lines P1 and P2 may be spaced apart from each other in a second direction Y (also referred to as a second horizontal direction). Both the first direction X and the second direction Y may be parallel to the back side 100b of the substrate 100 and may be perpendicular to the vertical direction Z. In some embodiments, the first direction X may be perpendicular to the second direction Y. The vertical direction Z may also be referred to as a third direction.

The first lower transistor of the wimpy transistor stack TSw_1 may include a plurality of first lower channel regions 202a (also referred to as a plurality of lower channel regions), a first lower source/drain region 204a (also referred to a lower source/drain region), a second lower source/drain region 204b, and a first lower gate structure 14a. The first lower source/drain region 204a may contact at least one of the plurality of first lower channel regions 202a. The first lower gate structure 14a may include a first lower gate insulator 206a, a first lower gate electrode 208a and a first lower gate spacer 210a. The plurality of first lower channel regions 202a may be provided in the first lower gate structure 14a. A first intergate insulator 304a (also referred to as an intergate insulator) may be provided between the first upper gate structure 12a and the first lower gate structure 14a.

The wimpy transistor stack TSw_1 may further include a first source/drain isolation layer 302a (also referred to as a source/drain isolation layer) separating the first upper source/drain region 404a from the first lower source/drain region 204a. As illustrated in FIG. 2, the first source/drain isolation layer 302a may include a first portion that is adjacent to the plurality of first upper channel regions 402a and has a first thickness t1 in the vertical direction Z. The first portion of the first source/drain isolation layer 302a may include an upper portion that extends into a space between a lowermost one of the plurality of first upper channel regions 402a and the first upper source/drain region 404a. As a result, as shown in FIG. 2, a lowermost one of the plurality of first upper channel regions 402a is electrically isolated from the first upper source/drain region 404a. In some embodiments, the upper portion of the first source/drain isolation layer 302a may contact the lowermost one of the plurality of first upper channel regions 402a. The upper portion of the first source/drain isolation layer 302a may contact an entirety of a side surface of the lowermost one of the plurality of first upper channel regions 402a facing the first upper source/drain region 404a, and thus the lowermost one of the plurality of first upper channel regions 402a may be electrically isolated from the first upper source/drain region 404a. Accordingly, the lowermost one of the plurality of first upper channel regions 402a does not flow current therethrough. The upper portion of the first source/drain isolation layer 302a may overlap the lowermost one of the plurality of first upper channel regions 402a in the first direction X, as illustrated in FIG. 2. An upper surface of the lowermost one of the plurality of first upper channel regions 402a may be spaced apart from the substrate 100 by a first distance d1 in the vertical direction Z, and an upper surface of the first source/drain isolation layer 302a (i.e., an upper surface of the first portion of the first source/drain isolation layer 302a) may be spaced apart from the substrate 100 by a second distance d2 in the vertical direction Z. The second distance d2 may be greater than or equal to the first distance d1 to electrically isolate the lowermost one of the plurality of first upper channel regions 402a from the first upper source/drain region 404a. By electrically isolating the lowermost one of the plurality of first upper channel regions 402a from the first upper source/drain region 404a, current flow through the first upper transistor of the wimpy transistor stack TSw_1 can be reduced, thereby reducing leakage current and/or power consumption of the device. Although FIG. 2 illustrates that the first source/drain isolation layer 302a separates (e.g., electrically isolate) only the lowermost one of the plurality of upper channel regions 402a from the first upper source/drain region 404a, in some embodiments, the first source/drain isolation layer 302a may also separate (e.g., electrically isolate) a further lowermost channels of the plurality of first upper channel regions 402a from the first upper source/drain region 404a.

The first portion of the first source/drain isolation layer 302a having the first thickness t1 in the vertical direction Z may also include a lower portion that extends into a space between an uppermost one of the plurality of first lower channel regions 202a and the first lower source/drain region 204a. As a result, as shown in FIG. 2, the uppermost one of the plurality of first lower channel regions 202a is electrically isolated from the first lower source/drain region 204a.In some embodiments, the lower portion of the first source/drain isolation layer 302a may contact the uppermost one of the plurality of first lower channel regions 202a. The lower portion of the first source/drain isolation layer 302a may contact an entirety of a side surface of the uppermost one of the plurality of first lower channel regions 202a facing the first lower source/drain region 204a and thus the uppermost one of the plurality of first lower channel regions 202a may be electrically isolated from the first lower source/drain region 204a. Accordingly, the uppermost one of the plurality of first lower channel regions 202a does not flow current therethrough. The lower portion of the first source/drain isolation layer 302a may overlap the uppermost one of the plurality of first lower channel regions 202a in the first direction X, as illustrated in FIG. 2. A lower surface of the uppermost one of the plurality of lower channel regions 202a may be spaced apart from the substrate 100 by a third distance d3 in the vertical direction Z, and a lower surface of the first source/drain isolation layer 302a (i.e., a lower surface of the first portion of the first source/drain isolation layer 302a) may be spaced apart from the substrate 100 by a fourth distance d4 in the vertical direction Z. The third distance d3 may be greater than or equal to the fourth distance d4 to electrically isolate the uppermost one of the plurality of first lower channel regions 202a from the first lower source/drain region 204a. By electrically isolating the uppermost one of the plurality of first lower channel regions 202a from the first lower source/drain region 204a, current flow through the first lower transistor of the wimpy transistor stack TSw_1 can be reduced, thereby reducing leakage current and/or power consumption of the device. Although FIG. 2 illustrates that the first source/drain isolation layer 302a separates only the uppermost one of the plurality of first lower channel regions 202a from the first lower source/drain region 204a, in some embodiments, the first source/drain isolation layer 302a may also separate (e.g., electrically isolate) further uppermost channels of the plurality of first lower channel regions 202a from the first lower source/drain region 204a.

Additionally, the wimpy transistor stack TSw_1 may include a second source/drain isolation layer 302b between the second upper source/drain region 404b and the second lower source/drain region 204b. The second source/drain isolation layer 302b may separate the second upper source/drain region 404b from the second lower source/drain region 204b and may have a second thickness t2 in the vertical direction Z. In some embodiments, the first thickness t1 may be greater than the second thickness t2. As illustrated in FIG. 2, all of the plurality of first upper channel regions 402a may contact the second upper source/drain region 404b, and all of the plurality of first lower channel regions 202a may contact the second lower source/drain region 204b. In some embodiments, the third thickness t3 may be greater than or equal to the first thickness 11. In such embodiments, the reference transistor stack TS would also be a wimpy transistor stack resulting in two wimpy transistors adjacent one another.

The first upper transistor and the first lower transistor of the wimpy transistor stack TSw_1 may have different conductivity types or may be of the same conductivity type. In some embodiments, the first upper transistor may be a P-type transistor, and the first lower transistor may be an N-type transistor. In some other embodiments, the first upper transistor may be an N-type transistor, and the first lower transistor may be a P-type.

The reference transistor stack TS may include a second upper transistor including a plurality of second upper channel regions 402b stacked in the vertical direction Z and a third upper source/drain region 404c. The first upper source/drain region 404a may be shared by the first upper transistor of the wimpy transistor stack TSw_1 and the second upper transistor of the reference transistor stack TS. All of the plurality of second upper channel regions 402b may contact both the first upper source/drain region 404a and the third upper source/drain region 404c and thus current flows therethrough. The first upper transistor of the wimpy transistor stack TSw_1 and the second upper transistor of the reference transistor stack TS may have the same conductivity type.

The reference transistor stack TS may further include a second lower transistor that is between the substrate 100 and the second upper transistor and includes a plurality of second lower channel regions 202b stacked in the vertical direction Z and a third lower source/drain region 204c. The first lower source/drain region 204a may be shared by the first lower transistor of the wimpy transistor stack TSw_1 and the second lower transistor of the reference transistor stack TS. All of the plurality of second lower channel regions 202b may contact both the second lower source/drain region 204a and the third lower source/drain region 204c, and thus current flows therethrough. The first lower transistor of the wimpy transistor stack TSw_1 and the second lower transistor of the reference transistor stack TS may have the same conductivity type.

The second upper transistor of the reference transistor stack TS may also include a second upper gate structure 12b. The second upper gate structure 12b may include a second upper gate insulator 406b, a second upper gate electrode 408b and a second upper gate spacer 410b. The plurality of second upper channel regions 402b may be provided in the second upper gate structure 12b. The second lower transistor of the reference transistor stack TS may also include a second lower gate structure 14b. The second lower gate structure 14b may include a second lower gate insulator 206b, a second lower gate electrode 208b and a second lower gate spacer 210b. The plurality of second lower channel regions 202b may be provided in the second lower gate structure 14b. A second intergate insulator 304b may be provided between the second upper gate structure 12b and the second lower gate structure 14b.

Still referring to FIG. 2, the first source/drain isolation layer 302a may also include a second portion that is adjacent to the plurality of second upper channel regions 402b and has a third thickness t3 in the vertical direction Z. The first thickness t1 of the first portion of the first source/drain isolation layer 302a may be thicker than the third thickness t3 of the second portion of the first source/drain isolation layer 302a. In some embodiments, the third thickness t3 may be equal to the second thickness t2 of the second source/drain isolation layer 302b. The reference transistor stack TS may also include a third source/drain isolation layer 302c between the third upper source/drain region 404c and the third lower source/drain region 204c. The third source/drain isolation layer 302c may separate the third upper source/drain region 404c and the third lower source/drain region 204c and may have a fourth thickness t4 in the vertical direction Z. The first thickness t1 of the first portion of the first source/drain isolation layer 302a may be thicker than the fourth thickness t4 of the third source/drain isolation layer 302c. In some embodiments, the fourth thickness t4 may be equal to the second thickness t2 of the second source/drain isolation layer 302b. In some embodiments, the third source/drain isolation layer 302c may not overlap the uppermost one of the plurality of first upper channel regions 402a and the lowermost one of the plurality of first lower channel regions 202a in the first direction X, as illustrated in FIG. 2. A fifth thickness t5 in the vertical direction Z of the first upper source/drain region 404a in a portion adjacent to the plurality of first upper channel regions 402a may be thinner than a sixth thickness t6 in the vertical direction Z of the first upper source/drain region 404a in a portion adjacent to the plurality of second upper channel regions 402b. A seventh thickness t7 in the vertical direction Z of the first lower source/drain region 204a in a portion adjacent to the plurality of first lower channel regions 202a may be thinner than an eighth thickness t8 in the vertical direction Z of the first lower source/drain region 204a in a portion adjacent to the plurality of second lower channel regions 202b.

Although FIG. 2 illustrates each transistor (e.g., the first upper transistor, the second upper transistor, the first lower transistor or the second lower transistor) includes three channel regions stacked in the vertical direction Z, in some embodiments, each transistor may include one, two, or more than three channel regions stacked in the vertical direction Z. In some embodiments, the first upper transistor of the wimpy transistor stack TSw_1 and the second upper transistor of the reference transistor stack TS may include an equal number of channel regions, and the first lower transistor of the wimpy transistor stack TSw_1 and the second lower transistor of the reference transistor stack TS may include an equal number of channel regions, as illustrated in FIG. 2. Accordingly, the channel regions of the wimpy transistor stack TSw_1 and the reference transistor stack TS can be formed using the same processes, and current flow through the wimpy transistor stack TSw_1 can be reduced by adjusting the thickness of the first source/drain isolation layer 302a. In some embodiments, a lower surface of the lowermost one of the plurality of first upper channel regions 402a and a lower surface of a lowermost one of the plurality of second upper channel regions 402b may be spaced apart from the substrate 100 by an equal distance in the vertical direction Z, and an upper surface of the uppermost one of the plurality of first lower channel regions 202a and an upper surface of an uppermost one of the plurality of second lower channel regions 202b may be spaced apart from the substrate 100 by an equal distance in the vertical direction Z, as illustrated in FIG. 2.

In some embodiments, a bottom insulator 102 may be provided on the substrate 100 and may separate the substrate 100 from the first lower source/drain region 204a, the second lower source/drain region 204b, and the third lower source/drain region 204c. Further, an insulation layer 104 may be provided on the wimpy transistor stack TSw_1 and the reference transistor stack TS.

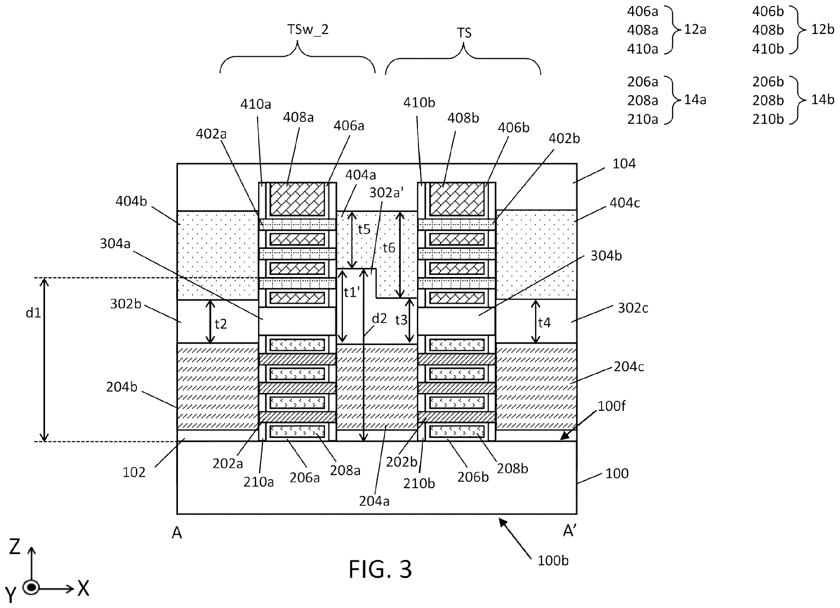

Referring to FIG. 3, the integrated circuit device is similar to that of FIG. 2, with primary differences being that a wimpy transistor stack TSw_2 is configured with none of the plurality of first lower channel regions 202a being electrically isolated due to the configuration of the first source/drain isolation layer 302a'. In other words, current can flow through all of the plurality of first lower channel regions 202a. As shown in FIG. 3, the first source/drain isolation layer 302a' includes an upper portion that extends into a space between the lowermost one of the plurality of first upper channel regions 402a and the first upper source/drain region 404a, but does not include a lower portion that extends into a space between the uppermost one of the plurality of first lower channel regions 202a and the first lower source/drain region 204a as shown in the embodiment of FIG. 2. As a result, a first thickness t1' in the vertical direction Z of the first source/drain isolation layer 302a' in a portion adjacent to the plurality of first upper channel regions 402a may be greater than a third thickness t3 in the vertical direction Z of the first source/drain isolation layer 302a' in a portion adjacent to the plurality of second upper channel regions 402b. A fifth thickness t5 in the vertical direction Z of the first upper source/drain region 404a in a portion adjacent to the plurality of first upper channel regions 402a may be thinner than a sixth thickness t6 in the vertical direction Z of the first upper source/drain region 404a in a portion adjacent to the plurality of second upper channel regions 402b.

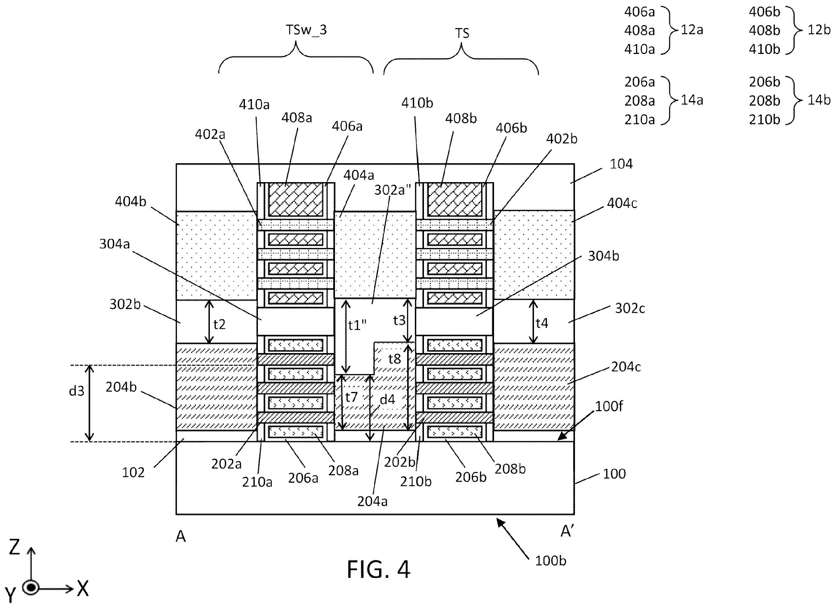

Referring to FIG. 4, the integrated circuit device is similar to that of FIG. 2, with primary differences being that a wimpy transistor stack TSw_3 is configured with none of the plurality of first upper channel regions 402a being electrically isolated due to the configuration of the first source/drain isolation layer 302a". In other words, current can flow through all of the plurality of first upper channel regions 402a. As shown in FIG. 4, the first source/drain isolation layer 302a" does not include an upper portion that extends into a space between the lowermost one of the plurality of first upper channel regions 402a and the first upper source/drain region 404a as shown in the embodiment of FIG. 2, but does include a lower portion that extends into a space between the uppermost one of the plurality of first lower channel regions 202a and the first lower source/drain region 204a. As a result, a first thickness t1" in the vertical direction Z of the first source/drain isolation layer 302a" in a portion adjacent to the plurality of first lower channel regions 202a may be greater than a third thickness t3 in the vertical direction Z of the first source/drain isolation layer 302a" in a portion adjacent to the plurality of second lower channel regions 202b. A seventh thickness t7 in the vertical direction Z of the first lower source/drain region 204a in a portion adjacent to the plurality of first lower channel regions 202a may be thinner than an eighth thickness t8 in the vertical direction Z of the first lower source/drain region 204a in a portion adjacent to the plurality of second lower channel regions 202b.

In the embodiments of FIGS. 1 through 4, the substrate 100 may include one or more semiconductor materials (e.g., Si, Ge, SiGe, GaP, GaAs, SiC, SiGeC and/or InP) and/or may include one or more insulating materials (e.g., silicon oxide, silicon oxynitride, silicon nitride, silicon carbonitride and/or a low-k material). In some embodiments, the substrate 100 may be a bulk substrate (e.g., a silicon wafer), a semiconductor on insulator (SOI) substrate or an insulating layer (e.g., a monolithic insulating layer). The low-k material may include, for example, fluorine-doped silicon oxide, organosilicate glass, carbon-doped oxide, porous silicon dioxide, porous organosilicate glass, spin-on organic polymeric dielectrics and/or spin-on silicon based polymeric dielectric.

Each of the first and second upper channel regions 402a and 402b and the first and second lower channel regions 202a and 202b may include independently, for example, one or more semiconductor materials (e.g., Si, Ge, SiGe, GaP, GaAs, SiC, SiGeC and/or InP). In some embodiments, each of the first and second upper channel regions 402a and 402b and the first and second lower channel regions 202a and 202b may be a nanosheet that may have a thickness in a range of from 1 nm to 100 nm in the vertical direction Z or may be a nanowire that may have a circular cross-section with a diameter in a range of from 1 nm to 100 nm.

Each of the first and second upper gate insulators 406a and 406b and the first and second lower gate insulators 206a and 206b may include an interfacial layer and/or a high-k material layer sequentially stacked on a channel region (e.g., one of the first and second upper channel regions 402a and 402b and the first and second lower channel regions 202a and 202b). For example, the interfacial layer may be a silicon oxide layer, and the high-k material layer may include, for example, hafnium silicate, zirconium silicate, hafnium dioxide and/or zirconium dioxide.

Each of the first and second upper gate electrodes 408a and 408b and the first and second lower gate electrodes 208a and 208b may include a work function layer and/or a metal gate layer. The work function layer may include, for example, one or more work function materials (e.g., a TiN layer, a TaN layer, a TiAl layer, a TiC layer, a TiAlC layer, a TiAlN layer and/or a WN layer). The metal gate layer may include, for example, tungsten (W), aluminum (Al) and/or copper (Cu).

Each of the first, second and third upper source/drain regions 404a, 404b, 404c and the first, second and third lower source/drain regions 204a, 204b, and 204c may include independently, for example, one or more semiconductor layers (e.g., a silicon layer and/or a silicon germanium layer) and may additionally include dopants in the one or more semiconductor layers.

Each of the first and second upper gate spacers 410a and 410b and the first and second lower gate spacer 210a and 210b may include independently, for example, silicon oxide, silicon oxynitride, silicon nitride and/or silicon carbonitride. Each of the first, second, and third source/drain isolation layers 302a, 302b, and 302c, the first and second intergate insulators 304a and 304b, the bottom insulator 102 and the insulation layer 104 may include independently, for example, one or more insulating materials (e.g., silicon oxide, silicon oxynitride, silicon nitride, silicon carbonitride and/or a low-k material).

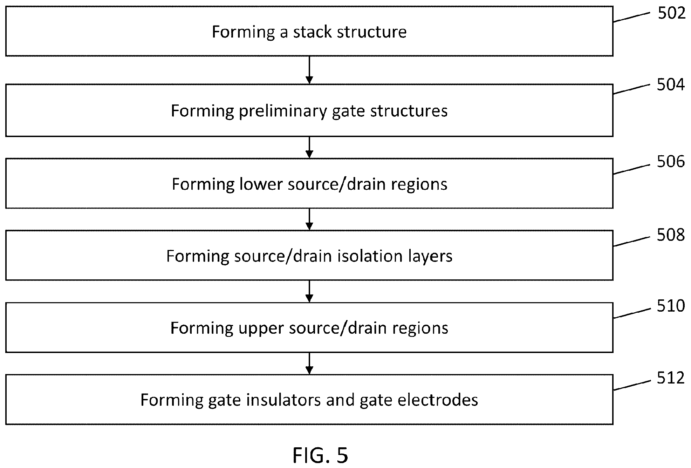

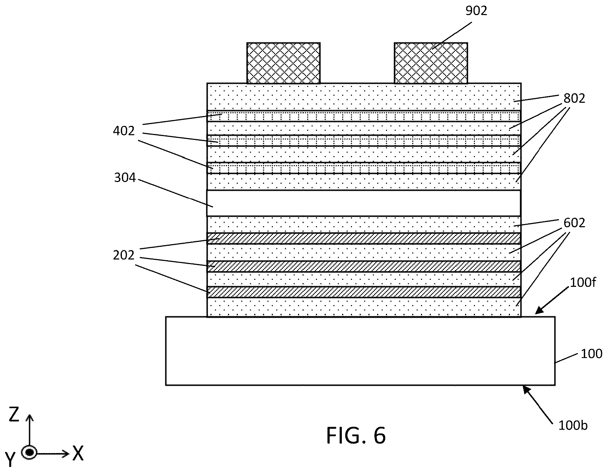

FIG. 5 is a flowchart of methods of forming an integrated circuit device according to some embodiments. FIGS. 6 through 12 are cross-sectional views illustrating methods of forming an integrated circuit device, such as the integrated circuit device of FIG. 2, according to some embodiments. Referring to FIGS. 5 and 6, the methods may include forming a stack structure on the substrate 100 (Block 502). The stack structure may include lower channel layers 202 that are alternately stacked with lower sacrificial layers 602, an intergate insulator layer 304 formed on the lower sacrificial layers 602, and upper channel layers 402 that are alternately stacked with upper sacrificial layers 802. Etching masks 902 may be formed on the upper sacrificial layers 802. The lower sacrificial layers 602 may include a material having an etch selectivity with respect to the lower channel layers 202, and the upper sacrificial layers 802 may include a material having an etch selectivity with respect to the upper channel layers 402. Each of the lower sacrificial layers 602 and the upper sacrificial layers 802 may include independently, for example, one or more semiconductor materials (e.g., Si, Ge, SiGe, GaP, GaAs, SiC, SiGeC and/or InP). For example, each of the lower sacrificial layers 602 and the upper sacrificial layers 802 may be a SiGe layer (e.g., a SiGe layer with an atomic concentration of germanium of about 20%).

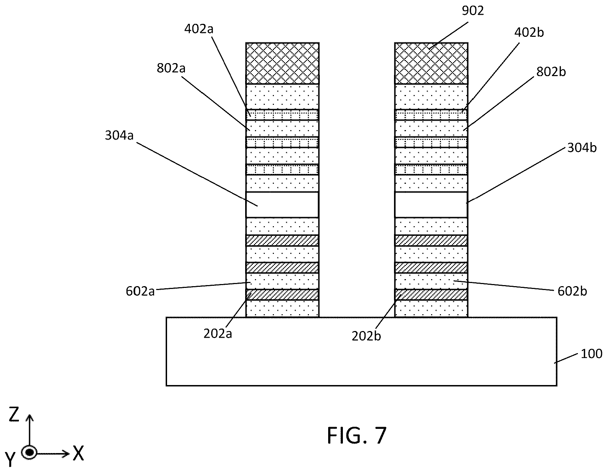

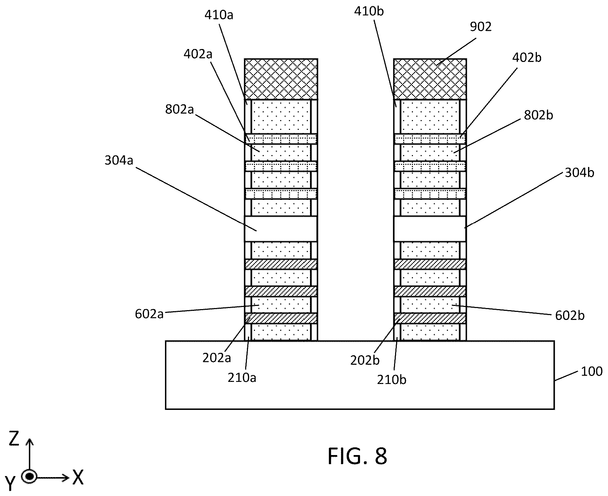

Referring to FIGS. 5 and 7, the stacked structure may be etched using, for example, a wet etching process and/or a dry etching process, to form the structures for a wimpy transistor stack TSw_1 (left stack) and a reference transistor stack TS (right stack). Preliminary gate structures are then formed as shown in FIG. 8 (Block 504). As shown in FIG. 8, the first and second upper gate spacers 410a and 410b may be formed on side surfaces of first and second upper sacrificial layers 802a and 802b, respectively, after a recess etch and the first and second lower gate spacers 210a and 210b may be formed on side surfaces of first and second lower sacrificial layers 602a and 602b, respectively. The preliminary gate structure for the wimpy transistor stack TSw_1 may include first upper channel regions 402a and first lower channel regions 202a, and the preliminary gate structure for the reference transistor stack TS may include second upper channel regions 402b and second lower channel regions 202b.

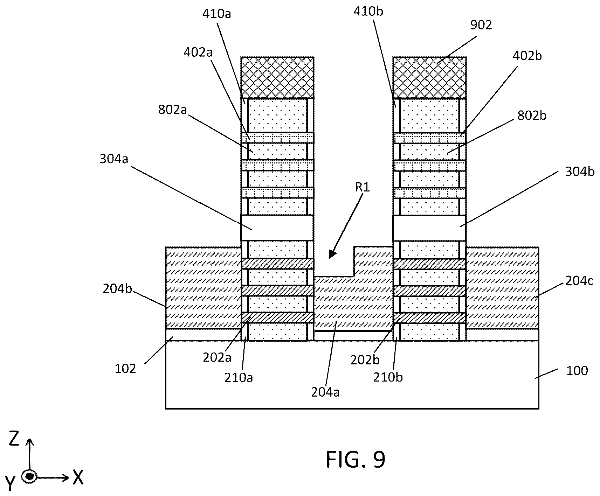

Referring to FIGS. 5 and 9, first, second and third lower source/drain regions 204a, 204b, and 204c may be formed (Block 506). The first, second and third lower source/drain regions 204a, 204b, and 204c may be formed by, for example, an epitaxial growth process. The first lower source/drain region 204a may be formed using both the first lower channel regions 202a and the second lower channel regions 202b as a seed layer, and the second lower source/drain region 204b may be formed using the first lower channel regions 202a as a seed layer, and the third lower source/drain region 204c may be formed using the second lower channel regions 202b as a seed layer. The first lower source/drain region 204a may include a first recess R1 adjacent to the first lower channel regions 202a. In some embodiments, the first lower source/drain region 204a may be formed to have a uniform thickness in the vertical direction Z and then a portion of the first lower source/drain region 204a may be etched to form the first recess R1. The first recess R1 may expose a side surface of an uppermost one of the first lower channel regions 202a. Before forming the first, second and third lower source/drain regions 204a, 204b, and 204c, a bottom insulator 102 may be formed on the substrate 100.

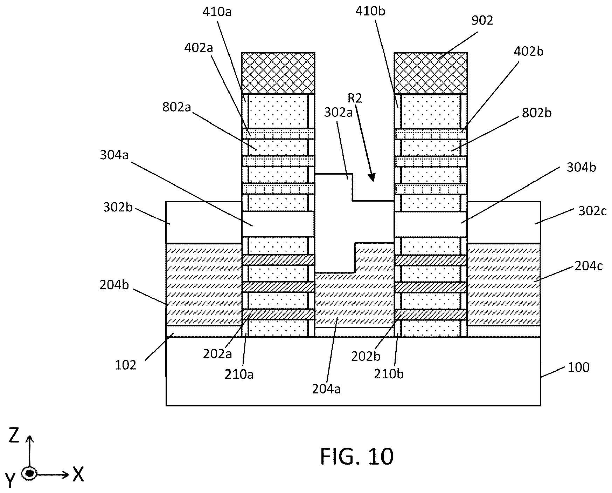

Referring to FIGS. 5 and 10, first, second and third source/drain isolation layers 302a, 302b, and 302c may be formed (Block 508). The first source/drain isolation layer 302a may include a second recess R2. In some embodiments, the first source/drain isolation layer 302a having a planar upper surface may be formed and then a portion of the first source/drain isolation layer 302a adjacent to the second upper channel regions 402b may be etched to form the second recess R2. The second recess R2 may expose a side surface of a lowermost one of the second upper channel regions 402b. In some embodiments, the first, second and third source/drain isolation layers 302a, 302b, and 302c may be deposited or grown to approximately the same thickness. A mask may be formed on a portion of the first source/drain isolation layer 302a adjacent the upper sacrificial layers 802a and then the first, second and third source/drain isolation layers 302a, 302b, and 302 may be etched such that the second recess R2 is formed in the first source/drain isolation layer 302a.

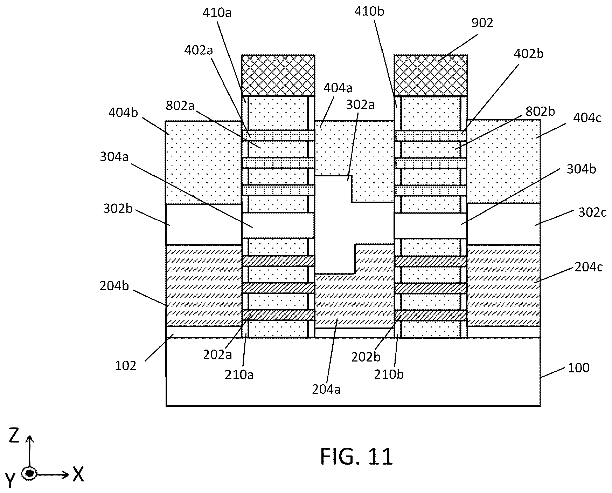

Referring to FIGS. 5 and 11, first, second and third upper source/drain regions 404a, 404b and 404c may be formed (Block 510). The first, second and third upper source/drain regions 404a, 404b and 404c may be formed by, for example, an epitaxial growth process. The first upper source/drain region 404a may be formed using both the first upper channel regions 402a and the second upper channel regions 402b as a seed layer, and the second upper source/drain region 404b may be formed using the first upper channel regions 402a as a seed layer, and the third upper source/drain region 404c may be formed using the second upper channel regions 402b as a seed layer.

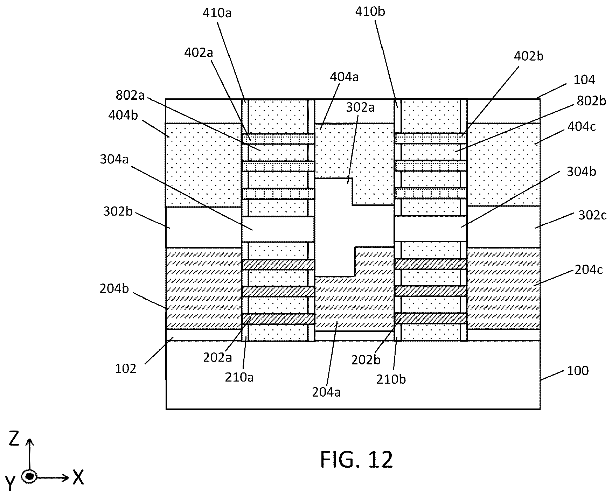

Referring to FIGS. 5 and 12, the etching masks 902 may be removed, and the insulation layer 104 may be formed on the first, second and third upper source/drain regions 404a, 404b and 404c. With removal of the etch mask 902, uppermost layers of the first and second upper sacrificial layers 802a and 802b may be exposed. Referring back to FIG. 2, gate insulators (e.g., the first and second upper gate insulators 406a and 406b and the first and second lower gate insulators 206a and 206b) and gate electrodes (e.g., the first and second upper gate electrodes 408a and 408b and the first and second lower gate electrodes 208a and 208b) may be formed (Block 512). The gate insulators and the gate electrodes may be formed in spaces from which the sacrificial layers (e.g., the first and second upper sacrificial layers 802a and 802b and the first and second lower sacrificial layers 602a and 602b) were removed.

FIGS. 13, 14 and 15 are cross-sectional views of the integrated circuit device taken along line A-A' in FIG. 1 according to some embodiments. Referring to FIG. 13, the integrated circuit device is similar to that of FIG. 2, with primary differences being that rather than use the first source/drain isolation layer 302a to electrically isolate the lowermost one of the plurality of first upper channel regions 402a and the uppermost one of the plurality of first lower channel regions 202a to reduce current flow through the wimpy transistor stack TSw _1, the thickness of a first intergate insulator 305a may be adjusted to vary the number of the plurality of first upper channel regions 402a and the number of the plurality of first lower channel regions 202a.

As shown in FIG. 13, a ninth thickness t9 of the first intergate insulator 305a of the wimpy transistor stack TSw_4 in the vertical direction Z may be greater than a tenth thickness t10 of the second intergate insulator 304b in the vertical direction Z. As a result, the first intergate insulator 305a may overlap a lowermost one of the plurality of second upper channel regions 402b and an uppermost one of the plurality of second lower channel regions 202b in the vertical direction Z. The second intergate insulator 304b may not overlap a lowermost one of the plurality of first upper channel regions 402a and an uppermost one of the plurality of first lower channel regions 202a in the vertical direction Z.

Due to the ninth thickness t9 of the first intergate insulator 305a, a number of the plurality of first upper channel regions 402a in the wimpy transistor stack TSw_4 may be less than a number of the plurality of second upper channel regions 402b in the reference transistor stack TS, and a number of the plurality of first lower channel regions 202a in the wimpy transistor stack TSw_4 may be less than a number of the plurality of second lower channel regions 202b in the reference transistor stack TS. Moreover, an upper surface of the first intergate insulator 305a and an upper surface of the lowermost one of the plurality of second upper channel regions 402b may be equidistant from the substrate 100, i.e., a seventh distance d7 may be equal to an eighth d8. A lower surface of the first intergate insulator 305a and a lower surface of the uppermost one of the plurality of second lower channel regions 202b may be likewise equidistant from the substrate 100, i.e., a ninth distance d9 may be equal to a tenth distance d10. Further, a fifth distance d5 from a lower surface of the lowermost one of the plurality of first upper channel regions 402a to an upper surface of the uppermost one of the plurality of first lower channel regions 202a may be greater than a sixth distance d6 from a lower surface of the lowermost one of the plurality of second upper channel regions 402b to an upper surface of the uppermost one of the plurality of second lower channel regions 202b.

Unlike the wimpy transistor stack TSw_1, TSw_2 and TSW_3 illustrated in FIGS. 2 through 4, a first source/drain isolation layer 302a of the wimpy transistor stack TSw_4 may have a thickness in the vertical direction Z, which is the same as or similar to thicknesses of the second and third source/drain isolation layer 302b and 302c, as illustrated in FIG. 13.

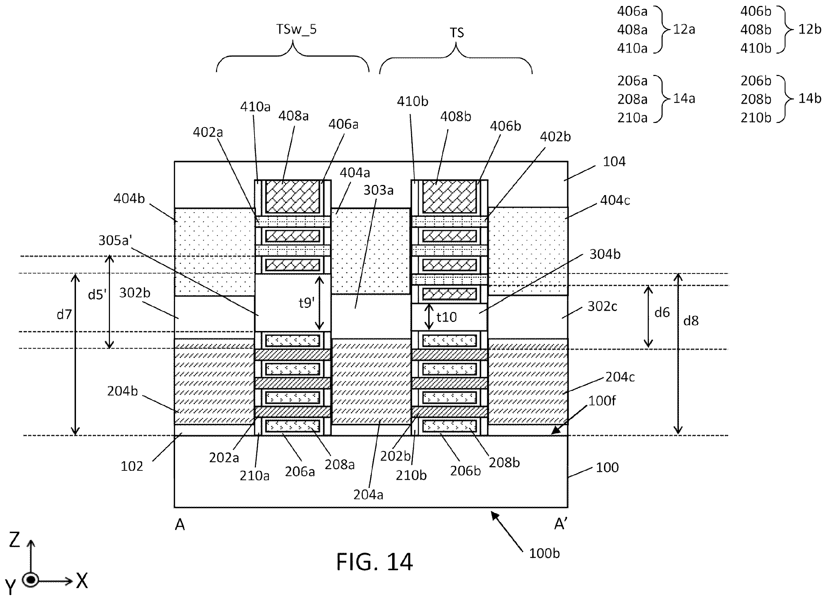

Referring to FIG. 14, the integrated circuit device is similar to that of FIG. 13, with primary differences being that the first intergate insulator 305a' of a wimpy transistor stack TSw_5 overlaps only a lowermost one of the plurality of second upper channel regions 402b without overlapping an uppermost one of the plurality of second lower channel regions 202b in the third direction Z. As a result, a number of the plurality of first upper channel regions 402a in the wimpy transistor stack TSw_5 may be less than a number of the plurality of second upper channel regions 402b in the reference transistor stack TS but a number of the plurality of first lower channel regions 202a in the wimpy transistor stack TSw_5 may be equal to a number of the plurality of second lower channel regions 202b in the reference transistor stack TS. The ninth thickness t9' of the first intergate insulator 305a' may be greater than the tenth thickness t10 of the second intergate insulator layer 304b. A fifth distance d5' from a lower surface of a lowermost one of the plurality of first upper channel regions 402a to an upper surface of an uppermost one of the plurality of first lower channel regions 202a may be greater than a sixth distance d6 from a lower surface of the lowermost one of the plurality of second upper channel regions 402b to an upper surface of the uppermost one of the plurality of second lower channel regions 202b.

As shown in FIG. 14, in some embodiments, an upper surface of the first intergate insulator 305a' may be farther than an upper surface of the second intergate insulator 304b from the substrate 100 in the vertical direction Z. Further, an upper surface of an uppermost one of the plurality of first upper channel regions 402a and an upper surface of an uppermost one of the plurality of second upper channel regions 402b may be equidistant from the substrate 100 in the vertical direction Z, and a lower surface of a lowermost one of the plurality of first upper channel regions 402a may be farther than a lower surface of a lowermost one of the plurality of second upper channel regions 402b from the substrate 100 in the vertical direction Z.

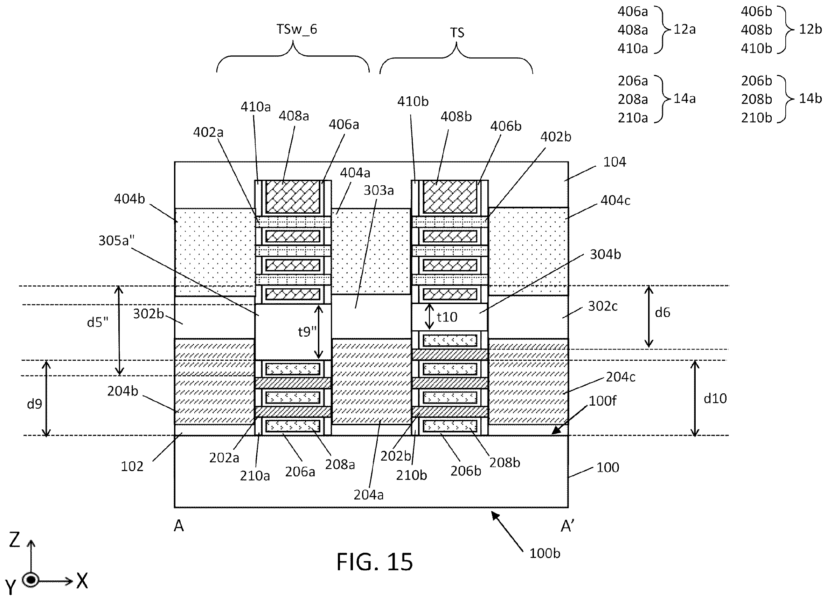

Referring to FIG. 15, the integrated circuit device is similar to that of FIG. 13, with primary differences being that the first intergate insulator 305a" of a wimpy transistor stack TSw_6 overlaps only an uppermost one of the plurality of second lower channel regions 202b without overlapping a lowermost one of the plurality of second upper channel regions 402b in the third direction Z. As a result, a number of the plurality of first lower channel regions 202a in the wimpy transistor stack TSw_6 may be less than a number of the plurality of second lower channel regions 202b in the reference transistor stack TS but a number of the plurality of first upper channel regions 402a in the wimpy transistor stack TSw_6 may be equal to a number of the plurality of second upper channel regions 402b in the reference transistor stack TS. The ninth thickness t9" of the first intergate insulator 305a" may be greater than the tenth thickness t10 of the second intergate insulator 304b. The fifth distance d5" from a lower surface of a lowermost one of the plurality of first upper channel regions 402a to an upper surface of an uppermost one of the plurality of first lower channel regions 202a may be greater than the sixth distance d6 from a lower surface of the lowermost one of the plurality of second upper channel regions 402b to an upper surface of the uppermost one of the plurality of second lower channel regions 202b in the vertical direction Z.

As shown in FIG. 15, in some embodiments, a lower surface of the first intergate insulator 305a" may be closer than a lower surface of the second intergate insulator 304b to the substrate 100 in the vertical direction Z. Further, a lower surface of a lowermost one of the plurality of first lower channel regions 202a and a lower surface of a lowermost one of the plurality of second lower channel regions 202b may be equidistant from the substrate 100 in the vertical direction Z, and an upper surface of an uppermost one of the plurality of first lower channel regions 202a may closer than an upper surface of an uppermost one of the plurality of second lower channel regions 202b to the substrate 100 in the vertical direction Z.

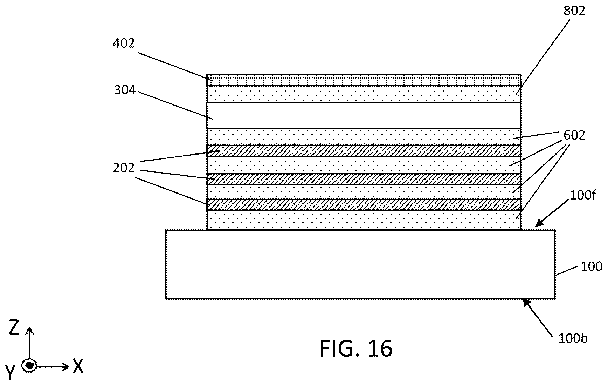

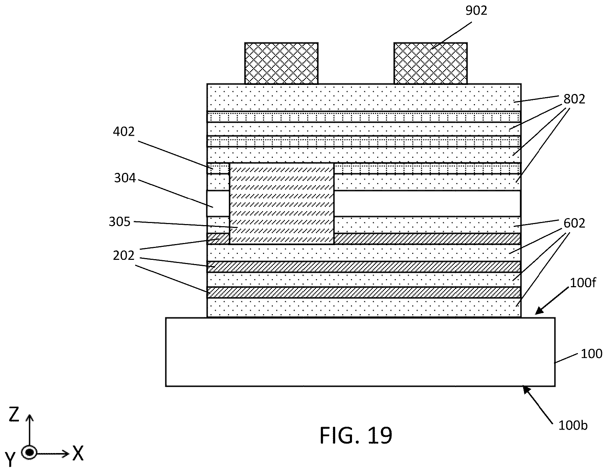

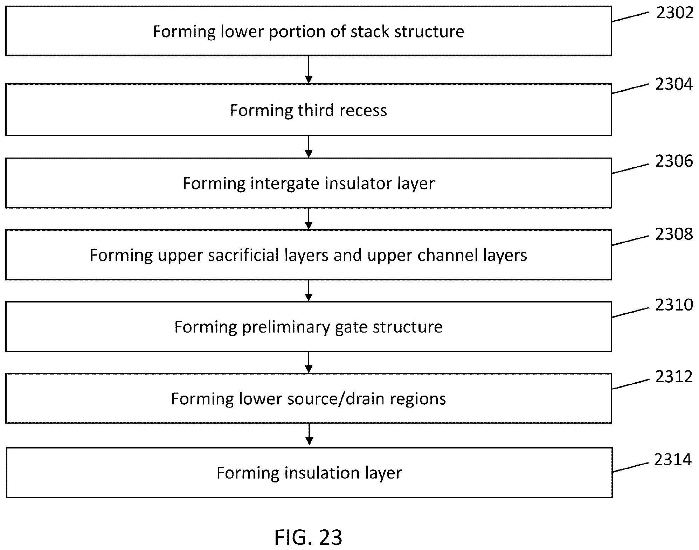

FIG. 23 is a flowchart of methods of forming an integrated circuit device according to some embodiments. FIGS. 16 through 22 are cross-sectional views illustrating methods of forming an integrated circuit device, such as the integrated circuit device of FIG. 13, according to some embodiments. The methods illustrated in FIGS. 16 through 22 are similar to the methods described with reference to FIGS. 5 through 12, with primary differences being that a stack structure (e.g., the structure shown in FIG. 19) includes a thick first intergate insulator layer 305 to form the first intergate insulator 305a of a wimpy transistor stack TSw_4.

Referring to FIGS. 16 and 23, a lower portion of a stack structure may be formed (Block 2302). The lower portion of the stack structure may include lower channel layers 202 that are alternately stacked with lower sacrificial layers 602, an intergate insulator layer 304 formed on the lower sacrificial layers 602, an upper sacrificial layer 802 (e.g., a lowermost one of upper sacrificial layers 802), and an upper channel layer 402 (e.g., a lowermost one of upper channel layers 402).

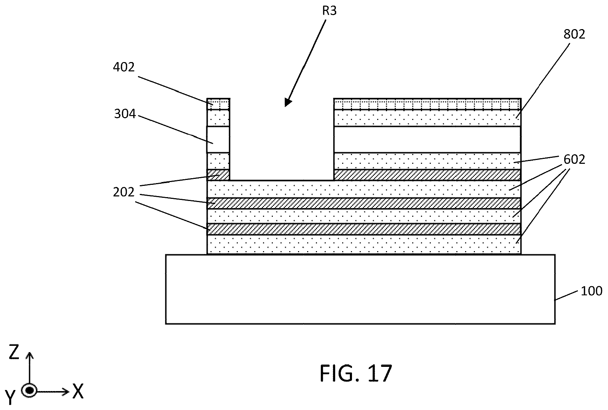

Referring to FIGS. 17 and 23, a third recess R3 may be formed in the lower portion of the stack structure shown in FIG. 16 by removing portions of the upper channel layer 402, the upper sacrificial layer 802, the intergate insulator layer 304, an uppermost one of the lower sacrificial layers 602 and an uppermost one of the lower channel layers 202 (Block 2304). The third recess R3 may be formed by, for example, a wet etching process and/or a dry etching process.

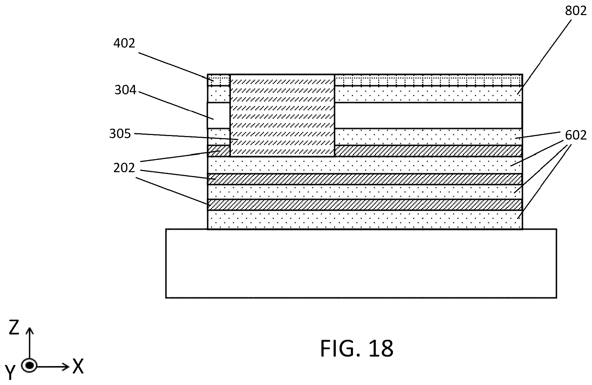

Referring to FIGS. 18 and 23, the first intergate insulator layer 305 may be formed in the third recess R3 using, for example, a deposition (Block 2306). The first intergate insulator layer 305 may include, for example, one or more insulating materials (e.g., silicon oxide, silicon oxynitride, silicon nitride, silicon carbonitride and/or a low-k material). In some embodiments, the first intergate insulator layer 305 and the intergate insulator layer 304 may include the same material. Referring to FIGS. 19 and 23, additional upper sacrificial layers 802 and upper channel region layers 402 may be formed in alternating fashion and then etching masks 902 may be formed on the resulting stack structure (Block 2308).

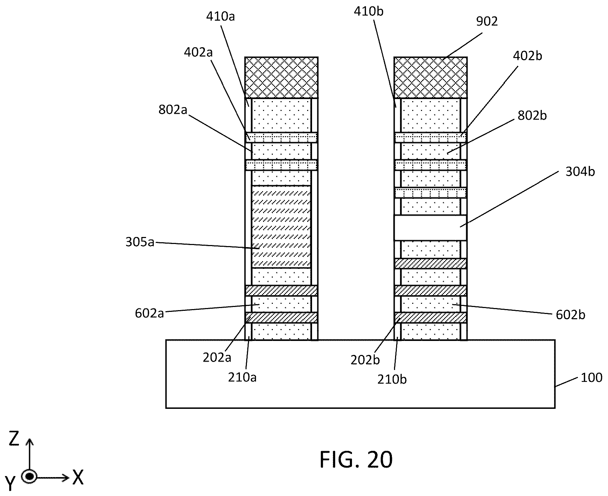

Referring to FIGS. 20 and 23, processes similar to those described with reference to FIGS. 7 and 8 may be performed to form a preliminary gate structure for a wimpy transistor stack TSw_4 (left structure) and a preliminary gate structure for a reference transistor stack TS (right structure) (Block 2310). The preliminary gate structure for the wimpy transistor stack TSw_4 may include a first intergate insulator 305a that is thicker than a second intergate insulator 304b of the preliminary gate structure for the reference transistor stack TS. A number of the plurality of first upper channel regions 402a in the preliminary gate structure for the wimpy transistor stack TSw_4 may be less than a number of the plurality of second upper channel regions 402b in the preliminary gate structure for the reference transistor stack TS, and a number of the plurality of first lower channel regions 202a in in the preliminary gate structure for the wimpy transistor stack TSw_4 may be less than a number of the plurality of second lower channel regions 202b in the preliminary gate structure for the reference transistor stack TS, as the portions of the upper channel layer 402 and the uppermost one of the lower channel layers 202 were removed while forming the third recess R3 (referring to FIG. 17).

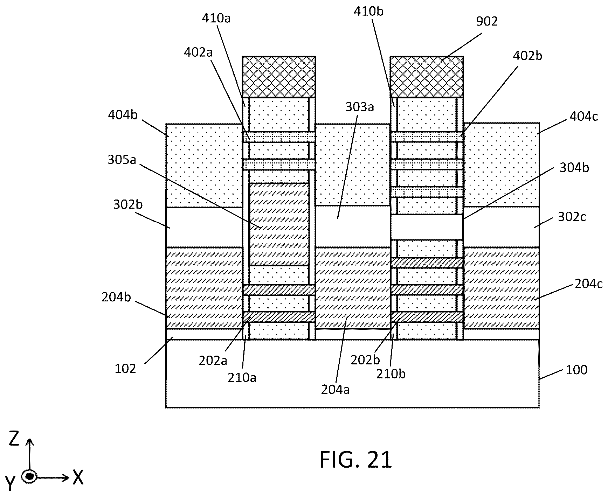

Referring to FIGS. 21 and 23, first, second and third lower source/drain regions 204a, 204b, and 204c may be formed by, for example, an epitaxial growth process (Block 2312). The first lower source/drain region 204a may be formed using both the first lower channel regions 202a and the second lower channel regions 202b as a seed layer, and the second lower source/drain region 204b may be formed using the first lower channel regions 202a as a seed layer, and the third lower source/drain region 204c may be formed using the second lower channel regions 202b as a seed layer. After then, first, second, and third isolation layers 302a, 302b, and 302c may be formed. First, second, and third upper source/drain regions 404a, 404b, and 404c may formed on the first, second and third isolation layers 302a, 302b, and 302c, respectively. The first, second and third upper source/drain regions 404a, 404b and 404c may be formed by, for example, an epitaxial growth process. The first upper source/drain region 404a may be formed using both the first upper channel regions 402a and the second upper channel regions 402b as a seed layer, and the second upper source/drain region 404b may be formed using the first upper channel regions 402a as a seed layer, and the third upper source/drain region 404c may be formed using the second upper channel regions 402b as a seed layer.

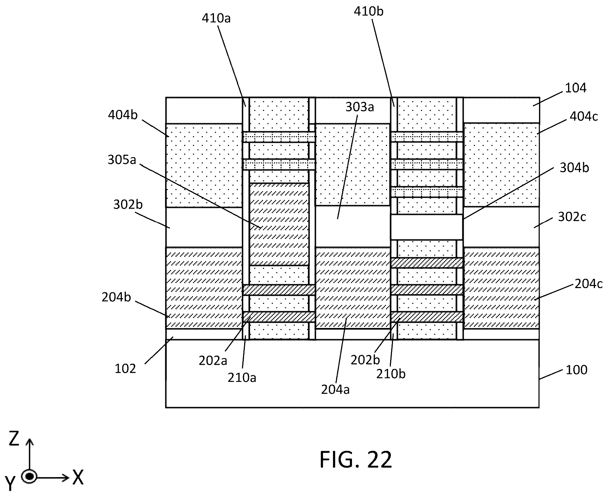

Referring to FIGS. 22 and 23, the etching masks 902 may be removed and the insulation layer 104 may be formed on the first, second and third upper source/drain regions 404a, 404b and 404c (Block 2314). With removal of the etch mask 902, uppermost layers of the first and second upper sacrificial layers 802a and 802b may be exposed. Referring back to FIG. 13, gate insulators (e.g., the first and second upper gate insulators 406a and 406b and the first and second lower gate insulators 206a and 206b) and gate electrodes (e.g., the first and second upper gate electrodes 408a and 408b and the first and second lower gate electrodes 208a and 208b) may be formed. The gate insulators and the gate electrodes may be formed in spaces from which the sacrificial layers (e.g., the first and second upper sacrificial layers 802a and 802b and the first and second lower sacrificial layers 602a and 602b) were removed.

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout the description. It is noted that aspects described with respect to one embodiment may be incorporated in different embodiments although not specifically described relative thereto. That is, all embodiments and/or features of any embodiments can be combined in any way and/or combination.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "connected" or "on," another element, it can be directly connected or on, the other element, or intervening elements may also be present. In contrast, when an element is referred to as being "directly connected" or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

As used herein, "a lower surface" refers to a surface facing a substrate (e.g., the substrate 100 in FIG. 2), and "an upper surface" refers to a surface opposite the lower surface. Further, as used herein, "a lower portion" refers to a portion that is closer than "an upper portion" to the substrate. Further, as used herein, "an element A overlapping an element B in a direction X" (or similar language) means that there is at least one line that extends in the direction X and intersects both the elements A and B.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. An integrated circuit device comprising:
a wimpy transistor stack (TSw) on a substrate (100),
wherein the wimpy transistor stack (TSw) comprises:
an upper transistor comprising:
a plurality of upper channel regions (402) stacked in a vertical direction (Z); and
an upper source/drain region (404) that contacts at least one of the plurality of upper channel regions (402);
a lower transistor that is between the substrate (100) and the upper transistor and comprises:
a plurality of lower channel regions (202) stacked in the vertical direction (Z); and
a lower source/drain region (204) that contacts at least one of the plurality of lower channel regions (202); and
a source/drain isolation layer (302) separating the upper source/drain region (404) from the lower source/drain region (204),
wherein the source/drain isolation layer (302) contacts, and/or overlaps in a horizontal direction (X), a lowermost one of the plurality of upper channel regions (402) and/or an uppermost one of the plurality of lower channel regions (202).

2. The integrated circuit device of claim 1, wherein the source/drain isolation layer (302) comprises an upper portion that extends into a space between the lowermost one of the plurality of upper channel regions (402) and the upper source/drain region (404), and/or
the source/drain isolation layer (302) comprises a lower portion that extends into a space between the uppermost one of the plurality of lower channel regions (202) and the lower source/drain region (204).

3. The integrated circuit device of claim 1 or 2, wherein the lowermost one of the plurality of upper channel regions (402) is electrically isolated from the upper source/drain region (404), and/or
the uppermost one of the plurality of lower channel regions (202) is electrically isolated from the lower source/drain region (204).

4. The integrated circuit device of any one of claims 1 to 3, wherein the source/drain isolation layer contacts the lowermost one of the plurality of upper channel regions (402), and
an upper surface of the lowermost one of the plurality of upper channel regions (402) is spaced apart from the substrate (100) by a first distance in the vertical direction (Z), an upper surface of the source/drain isolation layer (302) is spaced apart from the substrate (100) by a second distance in the vertical direction (Z), and the second distance is equal to or greater than the first distance.

5. The integrated circuit device of any one of claims 1 to 4, wherein the source/drain isolation layer contacts the uppermost one of the plurality of lower channel regions (202), and
a lower surface of the uppermost one of the plurality of lower channel regions (202) is spaced apart from the substrate (100) by a third distance in the vertical direction (Z), a lower surface of the source/drain isolation layer (302) is spaced apart from the substrate (100) by a fourth distance in the vertical direction (Z), and the third distance is equal to or greater than the fourth distance.

6. The integrated circuit device of any one of claims 1 to 5, wherein the upper source/drain region (404) is a first upper source/drain region (404a), the upper transistor further comprises a second upper source/drain region (404b), and the plurality of upper channel regions (402) are between the first upper source/drain region (404a) and the second upper source/drain region (404b), and
the second upper source/drain region (404b) contacts the plurality of upper channel regions (402),
preferably wherein the lower source/drain region (204) is a first lower source/drain region (204a), the lower transistor further comprises a second lower source/drain region (204b), and the plurality of lower channel regions (202) are between the first lower source/drain region (204a) and the second lower source/drain region (204b), and wherein:
the second lower source/drain region (204b) contacts the plurality of lower channel regions (202); and/or
the source/drain isolation layer (302) is a first source/drain isolation layer (302a), and the wimpy transistor stack (TSw) further comprises a second source/drain isolation layer (302b) separating the second upper source/drain region (404b) from the second lower source/drain region (204b); and/or
the first source/drain isolation layer (302a) has a first thickness (t1) in the vertical direction (Z), the second source/drain isolation layer (302b) has a second thickness (t2) in the vertical direction (Z), and the first thickness (t1) is greater than the second thickness (t2).

7. The integrated circuit device of claim 6, wherein the first source/drain isolation layer (302a) contacts both the first upper source/drain region (404a) and the first lower source/drain region (204a), and
the second source/drain isolation layer (302b) contacts both the second upper source/drain region (404b) and the second lower source/drain region (204b).

8. The integrated circuit device of any one of claims 1 to 7, wherein the upper transistor is a first upper transistor, the plurality of upper channel regions (402) are a plurality of first upper channel regions (402a), the upper source/drain region (404) is a first upper source/drain region (404a),
wherein the lower transistor is a first lower transistor, the plurality of lower channel regions (202) are a plurality of first lower channel regions (202a), and the lower source/drain region (204) is a first lower source/drain region (204a), and
wherein the integrated circuit device further comprises a transistor stack (TS) comprising:
a second upper transistor comprising a plurality of second upper channel regions (402b) stacked in the vertical direction (Z), the plurality of second upper channel regions (402b) contacting the first upper source/drain region (404a); and
a second lower transistor comprising a plurality of second lower channel regions (202b) stacked in the vertical direction (Z), the plurality of second lower channel regions (202b) contacting the first lower source/drain region (204a).

9. The integrated circuit device of claim 8, wherein:
the source/drain isolation layer (302) comprises a first portion adjacent to the plurality of first upper channel regions (402a) and a second portion adjacent to the plurality of second upper channel regions (402b), and
the first portion of the source/drain isolation layer (302) has a first thickness in the vertical direction (Z), and the second portion of the source/drain isolation layer (302) has a third thickness in the vertical direction (Z), and the first thickness is thicker than the third thickness; and/or
a number of the plurality of first upper channel regions (402a) is equal to a number of the plurality of second upper channel regions (402b), and a number of the plurality of first lower channel regions (202a) is equal to a number of the plurality of second lower channel regions (202b); and/or
a lower surface of a lowermost one of the plurality of first upper channel regions (402a) and a lower surface of a lowermost one of the plurality of second upper channel regions (402b) are spaced apart from the substrate (100) by an equal distance in the vertical direction (Z), and
an upper surface of an uppermost one of the plurality of first lower channel regions (202a) and an upper surface of an uppermost one of the plurality of second lower channel regions (202b) are spaced apart from the substrate (100) by an equal distance in the vertical direction (Z).

10. The integrated circuit device of claim 8 or 9, wherein:
the second upper transistor further comprises a third upper source/drain region (404c), wherein the plurality of second upper channel regions (402b) are between the first upper source/drain region (404a) and the third upper source/drain region (404c) and contact both the first upper source/drain region (404a) and the third upper source/drain region (404c);
the second lower transistor further comprises a third lower source/drain region (204c), wherein the plurality of second lower channel regions (202b) are between the first lower source/drain region (204a) and the third lower source/drain region (204c) and contact both the first lower source/drain region (204a) and the third lower source/drain region (204c); and
the transistor stack (TS) further comprises a third source/drain isolation layer (302c) separating the third upper source/drain region (404c) from the third lower source/drain region (204c), wherein the third source/drain isolation layer (302c) does not overlap the lowermost one of the plurality of first upper channel regions (402a) and the uppermost one of the plurality of first lower channel regions (202a) in the horizontal direction (X).

11. An integrated circuit device comprising:
a wimpy transistor stack (TSw) on a substrate (100),
wherein the wimpy transistor stack (TSw) comprises:
an upper transistor comprising:
a plurality of upper channel regions (402) stacked in a vertical direction (Z); and
an upper source/drain region (404) that contacts at least one of the plurality of upper channel regions (402); and
a lower transistor that is between the substrate (100) and the upper transistor and comprises:
a plurality of lower channel regions (202) stacked in the vertical direction (Z); and
a lower source/drain region (204) that contacts at least one of the plurality of lower channel regions (202),
wherein a lowermost one of the plurality of upper channel regions (402) is electrically isolated from the upper source/drain region (404), and/or an uppermost one of the plurality of lower channel regions (202) is electrically isolated from the lower source/drain region (204).

12. The integrated circuit device of claim 11, further comprising a source/drain isolation layer (302) separating the upper source/drain region (404) from the lower source/drain region (204),
wherein:
the source/drain isolation layer (302) separates the lowermost one of the plurality of upper channel regions (402) from the upper source/drain region (404), and/or the source/drain isolation layer (302) separates the uppermost one of the plurality of lower channel regions (202) from the lower source/drain region; and/or
the lowermost one of the plurality of upper channel regions (402) is electrically isolated from the upper source/drain region (404), and the source/drain isolation layer (302) comprises a portion that extends into a space between the lowermost one of the plurality of upper channel regions (402) and the upper source/drain region (404) and contacts the lowermost one of the plurality of upper channel regions; and/or
the uppermost one of the plurality of lower channel regions (202) is electrically isolated from the lower source/drain region (204), and the source/drain isolation layer (302) comprises a portion that extends into a space between the uppermost one of the plurality of lower channel regions (202) and the lower source/drain region (204) and contacts the uppermost one of the plurality of lower channel regions (202).

13. A method of forming an integrated circuit device, comprising:
forming (502) a stack structure on a substrate (100), the stack structure including lower channel layers (202) and lower sacrificial layers (602) that are alternately stacked, an intergate insulator layer (304) on the lower channel layers (202) and lower sacrificial layers (602), and upper channel layers (402) and upper sacrificial layers (802) that are alternately stacked;
etching the stack structure to form a wimpy transistor stack (TSw) and a reference transistor stack (TS);
forming (504) a first preliminary gate structure for the wimpy transistor stack (TSw) and a second preliminary gate structure for the reference transistor stack (TS);
forming (506) lower source/drain regions (204) adjacent the wimpy transistor stack (TSw) and the reference transistor stack (TS);
forming (508) source/drain isolation layers (302) on the source/drain regions, one of the source/drain isolation layers (302) contacting a lowermost one of the upper channel layers (402) or an uppermost one of the lower channel layers (202); and
forming (510) upper source/drain regions (404) on the source/drain isolation layers (302).

14. The method of claim 13, wherein each of the lower sacrificial layers (602) and the upper sacrificial layers (802) includes Si, Ge, SiGe, GaP, GaAs, SiC, SiGeC or InP.

15. The method of claim 13 or 14, wherein:
etching the stack structure to form the wimpy transistor stack (TSw) and the reference transistor stack (TS) comprises: dry etching or wet etching the stack structure to form the wimpy transistor stack (TSw) and the reference transistor stack (TS); and/or
forming (504) the first preliminary gate structure comprises: forming first upper gate spacers (410a) on side surfaces of the upper sacrificial layers (802) of the wimpy transistor stack (TSw) and first lower gate spacers (210a) on side surfaces of the lower sacrificial layers (602) of the wimpy transistor stack (TSw); and forming first upper gate spacers (410a) on side surfaces of the upper sacrificial layers (802) of the reference transistor stack (TS) and first lower gate spacers (210a) on side surfaces of the lower sacrificial layers (602) of the reference transistor stack (TS).
